**Europäisches Patentamt**

**European Patent Office**

**Office européen des brevets**

(19)

(11) Veröffentlichungsnummer: **0 069 903**

**B1**

(12)

# EUROPÄISCHE PATENTSCHRIFT

(45) Veröffentlichungstag der Patentschrift:
15.10.86

(21) Anmeldenummer: 82105680.1

(22) Anmeldetag: 26.06.82

(51) Int. Cl.⁴: **H 01 L 23/48,** H 01 L 21/60

(54) Elektrische Verbindungslasche für Halbleiterbauelemente.

(30) Priorität: 11.07.81 DE 3127458

(43) Veröffentlichungstag der Anmeldung:
19.01.83 Patentblatt 83/3

(45) Bekanntmachung des Hinweises auf die Patenterteilung:
15.10.86 Patentblatt 86/42

(84) Benannte Vertragsstaaten:
AT FR GB IT NL SE

(56) Entgegenhaltungen:
DE-A-2 728 330

(73) Patentinhaber: BROWN, BOVERI & CIE
Aktiengesellschaft, Kallstadter Strasse 1, D-6800
Mannheim 31 (DE)

(72) Erfinder: Neidig, Arno, Dr. Dipl.- Phys.,
Brühlerweg 42, D-6831 Plankstadt (DE)
Erfinder: Akyürek, Altan, Phys.- Ing. grad.,
Giessener Strasse 4, D-6148 Heppenheim (DE)
Erfinder: Hettmann, Hubert, Waldstrasse 16, D-6832
Hockenheim (DE)

(74) Vertreter: Kempe, Wolfgang, Dr., c/o Brown,
Boveri & Cie AG Postfach 351, D-6800 Mannheim
1 (DE)

EP 0 069 903 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf eine Verbindungslasche für ein Halbleiterbauelement zur elektrischen Verbindung eines Hauptbzw. Steuerkontaktes des Halbleiterbauelementes mit einer Leiterbahn, wobei die Verbindungslasche aus einem Bügel mit an beiden Enden doppelt abgewinkelten Lötfahnen bzw. Lötringen besteht.

Eine derartige Verbindungslasche ist beispielsweise aus dem Prospekt der Firma: Teccor Electronics Inc., Technical Data T-1064 bekannt und dient zur Verbindung der Kathode (Kathoden-Lasche) und des Gates (Gate-Lasche) einer Thyristor-Tablette mit dem Keramiksubstrat. Die Verlötung der Verbindungslasche mit der Halbleiter-Tablette und der Leiterbahn kann unter Zugabe von Flußmittel erfolgen, um vorhandene Oxide auf den zu lötenden Flächen zu reduzieren. Die Lötung bei höheren Temperaturen (ca. 350 C) mit Flußmittel und die anschließend notwendigen Reinigungsprozesse sind jedoch oft nicht verträglich mit der Passivierung von Aktivteilen oder anderen empfindlichen Bauteilen auf dem Keramiksubstrat. Ein weiterer Nachteil großflächiger Flußmittel-Lötungen ist der mögliche Einschluß von Lunkern, d.h. von Fehlstellen, die nicht gelötet sind. Dies führt zu unerwünscht hohen Wärmewiderständen.

Als Alternative zur Flußmittel-Lötung besteht die Lötung im Durchlaufofen unter Schutzgas-Atmosphäre. Hierzu ist jedoch eine genaue Justierung der Verbindungslasche und Halbleiter-Tablette mit Hilfe einer Lötform notwendig. Die bekannte Verbindungslasche weist den Nachteil auf, daß keine eindeutige Fixierung der Verbindungslasche während des Durchlaufs im Ofen möglich ist und so fehlerhafte Lötungen auftreten, die beispielsweise einen Kurzschluß zwischen Kathode und Gate des Halbleiterbauelements hervorrufen.

Der Erfindung liegt davon ausgehend die Aufgabe zugrunde, eine Verbindungslasche für ein Halbleiterbauelement zur elektrischen Verbindung eines Kontaktes des Halbleiterbauelements mit einer Leiterbahn anzugeben, die eine genaue Justierung zwischen Verbindungslasche und Halbleiterbauelement in einer Lötform ermöglicht.

Diese Aufgabe wird erfindungsgemäß dadurch gelöst, daß der Bügel der Verbindungslasche Seitenflügel aufweist, die zwischen den Abwinkelungen des Bügels zur Lötfahne, die zur Verbindung mit der Leiterbahn dient, angeordnet sind.

Die mit der Erfindung erzielbaren Vorteile liegen insbesondere darin, daß durch die Ausgestaltung der Verbindungslaschen mit Seitenflügeln eine genaue Justierung der Lasche zu der zugehörigen Halbleiter-Tablette mit geringen Toleranzen möglich wird. Dadurch werden Gate-Kathoden-Kurzschlüsse wirksam verhindert. Durch die Formgebung der Seitenflügel ist eine einfache Bestückung und Entstückung der Lötform ohne Zusatzvorrichtungen möglich.

Ausführungsbeispiele der Erfindung sind nachfolgend anhand der Zeichnungen erläutert. Es zeigen:

Fig. 1 ein Halbleiterbauelement mit Verbindungslaschen,

Fig. 2a,b,c eine Verbindungslasche für den Gate-Kontakt,

Fig. 3a,b,c eine Verbindungslasche für den Kathoden-Kontakt.

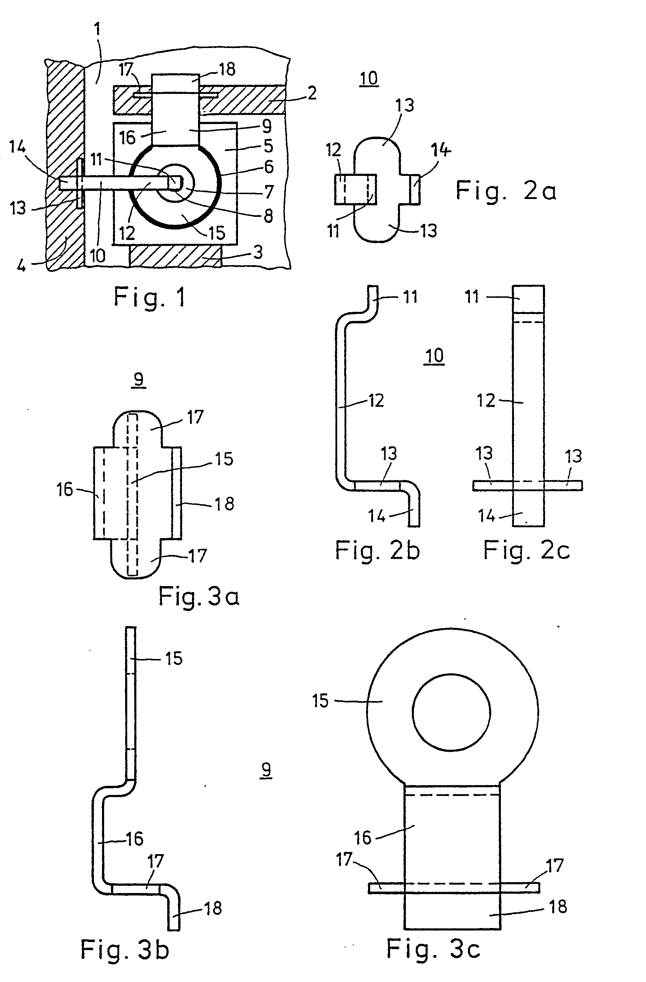

In Fig. 1 ist ein Halbleiterbauelement mit Verbindungslaschen dargestellt. Auf einer Keramikplatte 1 sind als Leiterbahnen dienende Kupferfolien 2, 3, 4 im Verfahren nach Patentanmeldung P 30 36 128. 5 aufgebracht. Die Kupferfolie 2 dient dabei als Kathodenzuführung, die Kupferfolie 3 als Anodenzuführung und die Kupferfolie 4 als Gatezuführung für eine Halbleiter-Tablette 5 (Halbleiteraktivteil), z.B. einen Thyristor. Die Halbleiter-Tablette 5 ist mit ihrer Anode auf der Kupferfolie 3 verlötet. Auf der der Anode gegenüberliegenden Seite weist die Halbleiter-Tablette 5 einen äußeren ringförmigen Kathodenkontakt 6 und einen inneren kreisförmigen Gatekontakt 8 (Zentralgate) auf, wobei zwischen Kathodenkontakt 6 und Gatekontakt 8 ein Isolierring 7 angeordnet ist.

Der Kathodenkontakt 6 der Halbleiter-Tablette 5 und die Kupferfolie 2 sind über eine Verbindungslasche 9 (Kathodenlasche 9) elektrisch miteinander verbunden, wobei die Lasche 9 an ihrem einen Ende mit der Kupferfolie 2, an ihrem anderen Ende mit dem Kathodenkontakt 6 verlötet ist. Der Gatekontakt 8 der Halbleiter-Tablette 5 und die Kupferfolie 4 sind über eine Verbindungslasche (Gate-Lasche 10) elektrisch miteinander verbunden, wobei die Lasche 10 an ihrem einen Ende mit der Kupferfolie 4, an ihrem anderen Ende mit dem Gatekontakt 8 verlötet ist.

In den Figuren 2a,b,c ist eine Verbindungslasche 10 für den Gatekontakt 8 dargestellt. Fig. 2b zeigt eine Seitenansicht der Gate-Lasche 10. Die Gate-Lasche 10 besitzt eine Lötfahne 11 zum Verlöten mit dem Gatekontakt 8 der Halbleiter-Tablette 5. Die Abmessungen der Lötfahne 11 entsprechen dabei dem Durchmesser des Gatekontaktes 8. An die Lötfahne 11 schließt sich doppelt abgewinkelt ein schmaler, langer Bügel 12 an. Der Bügel 12 geht doppelt abgewinkelt in eine Lötfahne 14 zum Verlöten der Lasche 10 mit der Kupferfolie 4 über. Zwischen erster und zweiter Abwinkelung des Bügels 12 zur Lötfahne 14 besitzt der Bügel 12 zwei Seitenflügel 13. Diese beiden Seitenflügel 13 schaffen eine definierte Stellung der Gate-Lasche 10 während des Lötens in einer Lötform, d.h. die Lötfahne 11 wird zum Verlöten genau über den Gatekontakt 8 der Halbleiter-Tablette 5 gebracht. Durch die Seitenflügel 13 wird ein seitliches Verrutschen der Lötfahne 11 verhindert. Fig. 2a zeigt eine Ansicht von oben auf die Gate-Lasche 10, woraus insbesondere die Ausführungsform der beiden Seitenflügel 13 ersichtlich ist. Fig. 2c zeigt eine Vorderansicht der Gate-Lasche 10, aus der insbesondere die Ausführungsform des schmalen Bügels 12 und der daran angeformten beiden Seitenflügel 13 zu erkennen sind.

In den Figuren 3a,b, c ist eine Verbindungslasche 9 für den Kathodenkontakt 6 dargestellt. Fig. 3b zeigt eine Seitenansicht der Kathoden-Lasche 9. Die Kathoden-Lasche 9 besitzt einen Lötring 15 zum Verlöten mit dem ringförmigen Kathodenkontakt 6 der Halbleiter-Tablette 5. Der Innendurchmesser des Lötringes 15 entspricht dabei ungefähr dem Außendurchmesser des Isolierringes 7 und der Außendurchmesser des Lötringes entspricht ungefähr dem Außendurchmesser des Kathodenkontaktes 6. An den Lötring 15 schließt sich doppelt abgewinkelt ein kurzer, breiter Bügel 16 an. Der Bügel 16 geht doppelt abgewinkelt in eine Lötfahne 18 zum Verlöten der Kathoden-Lasche 9 mit der Kupferfolie 2 über. Zwischen erster und zweiter Abwinkelung des Bügels 16 zur Lötfahne 18 besitzt der Bügel 16 zwei Seitenflügel 17. Die beiden Seitenflügel 17 schaffen eine definierte Stellung der Kathoden-Lasche 9 während des Lötens in einer Lötform, d.h. der Lötring 15 wird zum Verlöten genau über den Kathodenkontakt 6 der Halbleiter-Tablette 5 gebracht. Durch die beiden Seitenflügel 17 wird ein seitliches Verrutschen des Lötringes 15 verhindert.

Fig. 3a zeigt eine Vorderansicht der Kathoden-Lasche 9, woraus insbesondere die Ausführungsform der beiden Seitenflügel 17 ersichtlich ist.

Fig. 3c zeigt eine Ansicht von oben auf die Kathoden-Lasche 9, aus der insbesondere die Ausführungsform des Lötringes 15, des kurzen, breiten Bügels 16 und der daran angeformten beiden Seitenflügel 17 zu erkennen sind.

Zum Verlöten des Kathodenkontaktes 6 und des Gatekontaktes 8 der Halbleiter-Tablette 5 mit der Kathoden-Lasche 9 und der Gate-Lasche 10 werden die Verbindungslaschen 9 und 10 sowie die Halbleiter-Tablette 5 in die entsprechend ausgebildete Lötform eingelegt und die Lötverbindungen Kupferfolie 2-Lasche 9 sowie Kathodenkontakt 6 - Lasche 9 und Kupferfolie 4 - Lasche 10 sowie Gatekontakt 8 - Lasche 10 können gleichzeitig während eines Lötprozesses in einem Durchlaufofen unter Schutzgasatmosphäre hergestellt werden. Die Lötform wird dabei zweckmäßigerweise als wiederverwendbare Durchlaufform ausgestaltet und weist den Seitenflügeln 13 und 17 entsprechende Öffnungen auf.

Die elektrischen Verbindungslaschen 9 und 10 bestehen aus Kupfer, Nickel, Nickellegierungen oder Bronze und sind einseitig lotbeschichtet. Alternativ sind die Laschen vernickelt und es wird zum Verlöten der Teile mit zwischengelegten Lötplättchen gearbeitet. Die Dimensionierung der Bügel 12, 16 erfolgt unter Berücksichtigung der zu erwartenden Strombelastung, insbesondere Stoßstrombelastung. Die doppelte Abwinkelung der Bügel 12 und 16 an beiden Enden hat den Zweck, eventuell während des Betriebes des Halbleiterbauteiles auftretende mechanische Spannungen abzubauen.

**Patentansprüche**

1. Verbindungslasche für ein Halbleiterbauelement zur elektrischen Verbindung eines Haupt- bzw. Steuerkontaktes des Halbleiterbauelementes mit einer Leiterbahn, wobei die Verbindungslasche aus einem Bügel mit an beiden Enden doppelt abgewinkelten Lötfahnen bzw. Lötringen besteht, dadurch gekennzeichnet, daß der Bügel (12, 16) der Verbindungslasche (9, 10) Seitenflügel (13, 17) aufweist, die zwischen den Abwinklungen des Bügels (12, 16) zur Lötfahne (14, 18), die zur Verbindung mit der Leiterbahn (2, 4) dient, angeordnet sind.

2. Verbindungslasche nach Anspruch 1, dadurch gekennzeichnet, daß sie aus Kupfer, Messing, Nickellegierungen, Nickel oder Bronze besteht.

3. Verbindungslasche nach Anspruch 1 und 2, dadurch gekennzeichnet, daß sie auf der zu verlötenden Seite mit Löt beschichtet ist.

4. Verbindungslasche nach den Ansprüchen 1 und 2, dadurch gekennzeichnet, daß sie mit einer lötbaren Schicht beschichtet ist.

5. Verbindungslasche nach Anspruch 4, dadurch gekennzeichnet, daß die Schicht aus einer chemisch oder galvanisch aufgebrachten Nickelschicht besteht.

**Claims**

1. Connecting lug for a semi-conductor component for electrically connecting a main or control contact of the semi-conductor component to a conductor track, in which arrangement the connecting lug consists of a strap having solder tabs or solder rings which are doubly angled at both ends, characterised in that the strap (12, 16) of the connecting lug (9, 10) has side wings (13, 17) which are arranged between the angles of the strap (12, 16) to the solder tab (14, 18) used as connection to the conductor track (2, 4).

2. Connecting lug according to Claim 1, characterised in that it consists of copper, brass, nickel alloys, nickel or bronze.

3. Connecting lug according to Claim 1 and 2, characterised in that it is coated with solder on the side to be soldered.

4. Connecting lug according to Claims 1 and 2, characterised in that it is coated with a solderable layer.

5. Connecting lug according to Claim 4, characterised in that the layer consists of a nickel layer applied by chemical or electroplating means.

**Revendications**

1. Barrette de jonction pour un composant semiconducteur destiné à établir la connexion électrique entre un contact principal ou un contact de commande dudit composant semiconducteur et une bande conductrice, la barrette de jonction étant constituée par un étrier comportant aux deux extrémités des cosses ou des oeillets à souder couder deux fois, caractérisée par le fait que l'étrier (12, 16) de la barrette de jonction (9, 10) présente des ailettes latérales (13, 17) qui sont disposées entre les coudes de l'étrier (12, 16) en direction de la cosse à souder (14, 18) servant à établir la connexion avec la bande conductrice (2, 4).

2. Barrette de jonction selon la revendication 1, caractérisée par le fait qu'elle est réalisée en cuivre, en laiton, en alliages au nickel, en nickel ou en bronze.

3. Barrette de jonction selon les revendications 1 et 2, caractérisée par le fait qu'elle est recouverte de soudure sur le côté à souder.

4. Barrette de jonction selon la revendication 1 et 2, caractérisée par le fait qu'elle est recouverte d'une couche pouvant être soudée.

5. Barrette de jonction selon la revendication 4, caractérisée par le fait que la couche est constituée par une couche de nickel appliquée chimiquement ou electriquement.

Fig. 1

10

Fig. 2a

9

Fig. 3a

11

10

11

12

12

13

13

14

14

Fig. 2b

Fig. 2c

15

9

15

16

17

17

18

Fig. 3b

16

17

18

Fig. 3c